# EUROPEAN PATENT APPLICATION

(11) **EP 0 572 268 A1**
(43) Date of publication of application: **01.12.1993**
(21) Application number: 93304159.2
(22) Date of filing: 28.05.1993
(51) Int. Cl.: H05K 7/14

(54) **Backplane**

(30) Priority: 28.05.1992 GB 9211303
(71) Applicant: BICC Public Limited Company, London W1X 5FH (GB)
(72) Inventor: Lawrence, Howard, Southampton, Hampshire SO3 4RR (GB)
(74) Representative: Dlugosz, Anthony Charles

(57) **Abstract**

A backplane comprises a substantially rigid board (1) having a plurality of discrete elongate groups (2,2'2'') of plated through holes (4,4',4'') arranged substantially parallel to one another, each of which groups enables a daughter board to be connected to the backplane with the aid of a connector, the plated through holes (4) in each group being arranged in a number of columns and rows which have a pitch of about 2mm between the holes, each of a major proportion of the plated through holes of each group being electrically connected in series to a correspondingly positioned through hole in each of the other groups by means of a conductive track (8), which tracks together form a bus (6) for carrying traffic between the daughter boards, and other plated through holes being connected to a ground plane or to one or more power planes. The backplane includes a supplementary group of plated through holes (10) located at or near each end of the backplane for enabling the bus to be terminated by means of resistor packs and decoupling capacitors, each supplementary group of plated through holes being arranged in a pattern of columns and rows which columns are substantially parallel to the columns of, and which rows are in substantial alignment with the rows of, the plated through holes in each discrete group. The pattern of holes in the supplementary groups is such that holes in successive rows and columns are also arranged in an array of lines (16,18) that are inclined at an acute angle of about 38° to the columns so that the holes in the inclined lines are spaced 2.54mm (or multiples thereof) apart. This enables standard imperial resistor packs and capacitor packs to be employed for terminating the bus on a metric board.

## Description

This invention relates to backplanes for electronic equipment.

In complex electronic apparatus incorporating a plurality of circuit boards arranged with their major faces lying in substantially parallel planes, it is the general practice to interconnect circuits of such boards by means of multi-circuits and associated connectors carried on a board, frequently referred to as a mother board or backplane, to which edge connectors of said plurality of circuit boards, frequently referred to as daughter boards, are permanently or detachably connected.

A backplane normally comprises a substantially rigid board having a plurality of discrete elongate groups of holes whose boundary walls are coated with a metal e.g. an alloy such as solder (such holes referred to herein as "plated through holes") the groups of holes being arranged substantially parallel to one another, each of which groups enables a daughter board to be connected to the backplane with the aid of a connector. Each of a major proportion of the plated through holes of each group are electrically connected in series to a correspondingly positioned through hole in each of the other groups by means of a conductive track, which tracks together form a bus for carrying traffic between the daughter boards, and other plated through holes are connected to a ground plane or to one or more power planes. The backplane may include a supplementary group of plated through holes located at or near each end of the backplane for enabling the bus to be terminated by means of resistor packs and capacitors, the resistor packs providing impedance matched resistors between the signal lines of the bus and the power plane and the decoupling capacitors being connected between the power plane and the ground plane.

In one such backplane which is currently widely used and which is generally known as the "Futurebus" backplane, each discrete group of plated through holes comprises three columns each of 32 mutually spaced holes, the pitch between adjacent holes in each column and in each row being 2.54mm or 0.1 inch. At each end of a "Futurebus" backplane the signal lines are electrically connected via resistor packs to the or a powerbus carried by the board and the ground lines - which are substantially evenly distributed in each group of holes - are electrically connected to this powerbus via decoupling capacitor packs. Each resistor pack and each capacitor pack comprises an elongate body of electrically insulating material in which the or each resistor or capacitor is encapsulated and from which protrude a plurality of electrically conductive leads which are mutually spaced along the pack and which extend in substantially the same direction as one another, the pitch between adjacent leads being 2.54mm or an integer multiple thereof. Some of the leads of each resistor pack are soldered in plated through holes electrically connected to a plurality of signal lines and the other leads of the resistor packs are soldered in plated through holes electrically connected to the or a powerbus and some of the leads of each capacitor pack are soldered in plated through holes electrically connected to a plurality of ground lines and the other leads of the capacitor packs are soldered in plated through holes electrically connected to this powerbus. Whilst the "Futurebus" backplane has been found to be suitable for accommodating the bit rate of the digital signals transmitted by electronic apparatus hitherto in use, it has been found that it cannot accommodate the high bit rate of the digital signals transmitted by the more complex electronic apparatus now to be employed, with the result that the transmitted digital signals are inevitably delayed, attenuated or distorted.

With a view to providing a backplane which will have greater flexibility and enhanced performance, a backplane has been proposed - known as the "Futurebus+" backplane - in which each discrete group of plated through holes to which an edge connector of a daughter board can be electrically connected consists of four columns of 48 holes, the pitch between adjacent holes in each column and in each row being 2mm. Apart from electronic changes, the Futurebus+ backplane differs from earlier backplanes in that the pitch between adjacent holes in the discrete groups of holes has been reduced from 2.54mm to 2mm, the groups comprising four columns of 48 holes. As a consequence of the shorter pitch between plated through holes in each group, standard resistor packs and capacitor packs cannot be readily directly electrically connected between signal lines or ground lines and the or a powerbus and several alternative terminating arrangements have been proposed which necessitate the use of a modified backplane in which a powerbus is separately formed with respect to and is spaced from the rear face of the backplane and of a supplementary component or supplementary components for accommodating the resistor and capacitor packs.

It is an object of the present invention to provide an improved backplane of the kind described which can be directly terminated using standard resistor packs and capacitor packs and which thereby enables use to be readily made of the greater flexibility and enhanced performance of the "Futurebus+" backplane.

According to the present invention, in a backplane in which the plated through holes in each discrete group are arranged in a number of columns and rows which have a pitch of about 2mm between the holes, each supplementary group of plated through holes is arranged in a pattern of columns and rows which columns are substantially parallel to the columns of, and which rows are in substantial alignment with the rows of, the plated through holes in each discrete group, the pattern being such that holes in successive rows and columns are also arranged in an array of lines that are inclined at an acute angle to the columns in which lines the holes are spaced about 2.54mm apart.

When the improved backplane of the kind described is to be used, leads of standard resistor packs can be readily soldered or otherwise fitted in the appropriate plated through holes in any one of said inclined lines of mutually spaced holes in which the pitch between adjacent holes is 2.54mm.

Normally the holes in the columns of each supplementary group are arranged with a pitch of 4mm rather than 2mm, and the holes in alternate columns of each supplementary group are staggered by 2mm so that each row of holes in the supplementary groups will contain at most only about half the number of holes as there are columns in the supplementary group.
Preferably in some of the columns of the supplementary group of holes are arranged with a pitch that alternates between 4mm and 8mm so that some of the holes in some of the inclined lines are separated by 5.08mm. Each such inclined line is advantageously interposed between pairs of inclined lines of holes separated by 2.54mm, and the pitch between adjacent holes preferably alternates between 5.08mm and 7.62 mm. In such inclined line, pairs of the holes are electrically connected to the ground plane and the or a power plane. Such lines of holes can accommodate the leads of standard capacitor packs to be employed as decoupling capacitors.

The backplane according to the invention has the further advantage that it is possible for tracks extending from the discrete groups of plated through holes to pass through the supplementary group with little or no requirement for bends in the tracks since the supplementary group of holes presents the same hole spacing as that of the discrete group of holes when viewed from the discrete group. In contrast if the resistor and capacitor packs were to be mounted in parallel with the discrete groups of holes, the difference between the 2mm pitch in the discrete groups and the 2.54mm pitch of the resistor pack leads would require bends in some of the tracks in order for them to extend beyond the resistor loads, which bends can cause reflections in signals travelling along the tracks.

One form of backplane will now be described by way of example with reference to the accompanying drawings in which:
Figure 1 is a top plan view of part of a multilayer backplane; and
Figure 2 is a plan view of a sub-layer of the backplane of Figure 1.

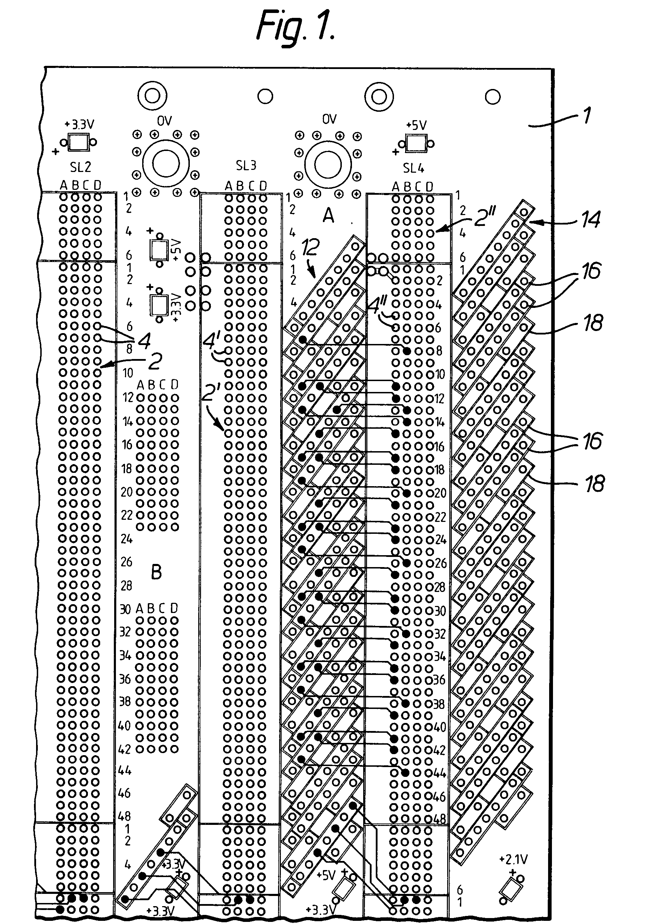

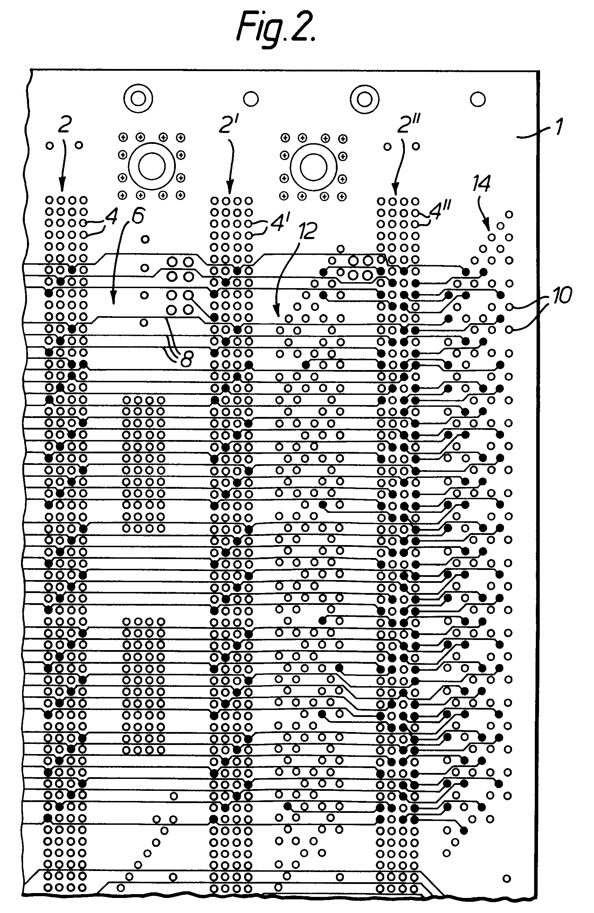

Referring to the accompanying drawings, a backplane comprises a rigid board 1 of insulating material that is formed in a number of layers, the top layer being shown in figure 1 and a sub-layer shown in figure 2. The board has an array of elongate discrete groups 2, 2' and 2'' of metal plated through holes 4, 4' and 4'' arranged across the board in order to enable a number of daughter boards to be connected to the backplane by means of edge connectors. The backplane also includes a bus 6 extending across the backplane to carry traffic between different daughter boards, the bus being formed from an array of generally parallel tracks 8 that are formed on the sub-layer and extend perpendicularly to the discrete groups 2 of through holes and connect correspondingly positioned holes 4 in each group. Each group 2 comprises 192 holes 4 arranged in four columns and 48 rows, the holes in the rows and columns having a spacing of 2mm.

In order to terminate each end of the bus 6, the tracks 8 forming the signal lines must be connected to a power plane (formed on a different sub-layer) by resistors having an appropriate resistance (e.g. 33 ohms) and the power plane and ground plane must be connected by decoupling capacitors, the resistors and capacitors being provided in the form of packs having a number of leads extending from a single body.

This is achieved by means of a group of supplementary plated through holes 10 that is divided longitudinally into two sub-groups 12 and 14, one subgroup being arranged on each side of the discrete group 2'' of plated through holes that is located at the end of the bus 8. A corresponding group of supplementary plated through holes is arranged at the discrete group of holes (not shown) located at the other end of the bus. The sub-groups of holes are arranged in eight columns, the first, third, sixth and eight of which having holes with a spacing of 4mm so that the holes 10 are in register with alternate rows of holes 4 in the group 2''. In the second, fourth, fifth and seventh columns of the sub-groups 12 and 14 the hole spacing alternates between 4mm and 8mm. The holes in successive columns of each sub-group 12 and 14 are staggered by 4mm, and the columns are separated by 1.57mm so that the holes in each sub-group are also arranged in an array of rows 16 and 18 that are inclined at an angle of 38° to the columns. The rows 16 each contain eight holes that are separated by 2.54mm (0.1 inch) and every third row (designated 18) contains four holes that are separated by distances of 5.08, 7.62 and 5.08mm (0.2, 0.3 and 0.2 inch) respectively.

In order to terminate the bus 6, standard imperial resistor packs can be inserted into the rows 16 and capacitor packs inserted into the rows 18.

Because the holes 10 of the sub-group 12 are all in register with the holes 4 of the discrete group 2, the tracks 8 of the bus 6 can extend through the subgroup 12 without the need to include any bends, thereby reducing the possibility of signal reflections in the bus.

## Claims

1. A backplane which comprises a substantially rigid board (1) having a plurality of discrete elongate groups (2,2',2'') of plated through holes (4,4',4'') arranged substantially parallel to one another, each of which groups enables a daughter board to be connected to the backplane with the aid of a connector, the plated through holes (4) in each group being arranged in a number of columns and rows which have a pitch of about 2mm between the holes, each of a major proportion of the plated through holes of each group being electrically connected in series to a correspondingly positioned through hole in each of the other groups by means of a conductive track (8), which tracks together form a bus (6) for carrying traffic between the daughter boards, and other plated through holes being connected to a ground plane or to one or more power planes, the backplane including a supplementary group of plated through holes (10) located at or near each end of the backplane for enabling the bus to be terminated by means of resistor packs and decoupling capacitors, each supplementary group of plated through holes being arranged in a pattern of columns and rows which columns are substantially parallel to the columns of, and which rows are in substantial alignment with the rows of, the plated through holes in each discrete group, the pattern being such that holes in successive rows and columns are also arranged in an array of lines (16,18) that are inclined at an acute angle to the columns, in at least some of which lines the holes are spaced about 2.54mm apart.

2. A backplane as claimed in claim 1, wherein the holes (10) in the columns of each supplementary group are arranged with a pitch of about 4mm, the holes in alternate columns of each supplementary group being staggered by 2mm.

3. A backplane as claimed in claim 2, wherein, in some of the columns of the supplementary group the holes are arranged with a pitch that alternates between 4mm and 8mm so that some of the holes in some of the inclined lines are separated by 5.08mm.

4. A backplane as claimed in claim 3, wherein each inclined line (18) that contains holes separated by 5.08mm is interposed between pairs of inclined lines (16) of holes separated by 2.54mm, and the pitch between adjacent holes alternates between 5.08mm and 7.62mm, pairs of the holes being electrically connected to the ground plane and the or a power plane.

5. A backplane as claimed in any one of claims 1 to 4, wherein the discrete groups (2,2',2'') of plated through holes are arranged in a line extending across the rigid board, and a supplementary group of plated through holes (10) is located in the region of the discrete group of holes at each end of the line.

6. A backplane as claimed in claim 5, wherein each supplementary group of plated through holes (10) is divided lengthwise into two sub-groups (12,14) that are located on opposite sides of its associated discrete group (2) of holes.
